# DEMANDE DE BREVET EUROPEEN

(11) **EP 3 783 642 A1**
(43) Date de publication de la demande: **24.02.2021**
(21) Numéro de dépôt: 20190979.3
(22) Date de dépôt: 13.08.2020
(51) Int. Cl.: H01L 21/762, H01L 21/268, H01L 21/324

(54) **PROCÉDÉ DE GUÉRISON D'UNE COUCHE IMPLANTÉE COMPRENANT UN TRAITEMENT THERMIQUE PRÉALABLE À UNE RECRISTALLISATION PAR RECUIT LASER**

(30) Priorité: 20.08.2019 FR 1909297
(71) Demandeur: Commissariat à l'énergie atomique et aux énergies alternatives, 75015 Paris (FR)
(72) Inventeur: ACOSTA ALBA, Pablo, 38054 GRENOBLE CEDEX 09 (FR); REBOH, Shay, 38054 GRENOBLE CEDEX 09 (FR)
(74) Mandataire: Brevalex

(57) **Abrégé**

L'invention porte sur un procédé de guérison de défauts liés à une implantation d'espèces réalisée dans un substrat donneur (1) en un matériau semi-conducteur pour y former un plan de fragilisation (5) séparant une couche mince (4) d'une partie massive du substrat donneur. Le procédé comporte une amorphisation superficielle de la couche mince, suivie de l'application d'un traitement thermique à la couche mince superficiellement amorphisée. Le procédé comprend, après le traitement thermique, l'application d'un recuit laser à la couche mince superficiellement amorphisée pour la recristalliser en phase solide.

## Description

### DOMAINE TECHNIQUE

Le domaine de l'invention est celui des procédés de transfert d'une couche semi-conductrice d'un substrat donneur vers un substrat receveur qui mettent en œuvre une fracture le long d'un plan de fragilisation formé par implantation d'espèces dans le substrat donneur. L'invention concerne plus particulièrement la guérison de défauts causés par l'implantation.

### TECHNIQUE ANTÉRIEURE

La technologie Smart Cut™ est une technique bien connue pour permettre le transfert de couches minces de matériaux semi-conducteurs. Selon cette technique, des espèces ioniques telles que de l'hydrogène et/ou de l'hélium sont implantées dans un substrat donneur afin d'y former un plan de fragilisation. Le substrat donneur est par la suite mis en contact avec un substrat receveur, par exemple par collage direct. Cette technique fait ensuite appel au développement des défauts générés au niveau du plan de fragilisation. Ce développement implique un apport énergétique, généralement réalisé au moyen d'un traitement thermique de quelques centaines de degrés, 500°C typiquement, pendant quelques dizaines de minutes. Cela conduit à la formation d'une couche confinée de cavités et de microfissures au sein de laquelle va s'initier et se propager une fracture. Cette fracture sépare le substrat donneur le long du plan de fragilisation et une couche mince du substrat donneur est ainsi transférée sur le substrat receveur.

Après le transfert, des défauts sont présents dans la couche mince transférée qui a été traversée par les espèces implantées. Ces défauts peuvent notamment correspondre à des défauts dans le réseau cristallin de la couche ou à des résidus des espèces implantées. De tels défauts dégradent fortement le fonctionnement des dispositifs électroniques formés dans ou sur la couche transférée. Il est donc nécessaire de les guérir. La technique couramment utilisée pour réaliser cette guérison est un traitement thermique à haute température. Ce traitement thermique atteint généralement des températures supérieures à 900°C, typiquement 1100-1200°C et dure quelques secondes (environ 30 secondes pour un recuit thermique rapide RTA (« Rapid Thermal Annealing ») ou quelques minutes, voire quelques heures, dans un four vertical. Dans tous les cas, l'intégralité du substrat receveur sur lequel la couche mince a été transférée subit un traitement thermique bien au-delà de 500°C.

La mise en œuvre de cette technique de guérison n'est néanmoins pas envisageable lorsque que la couche mince est transférée sur un substrat receveur susceptible d'être endommagé par l'application d'un traitement thermique à haute température. C'est le cas par exemple des substrats en polymère utilisés notamment en électronique flexible ou encore des substrats en verre qui fondent à une température proche de 600°C. C'est également le cas en intégration 3D séquentielle où les substrats présentent déjà des composants partiellement ou totalement fabriqués et comprennent donc éventuellement des lignes de cuivre qui se dégradent à partir de 400°C-500°C, des contacts en siliciure de nickel dont la conductivité peut être détériorée au-delà de 550°C, etc.

Une solution de guérison alternative consiste à générer une amorphisation partielle, le plus souvent par implantation ionique, de la couche mince transférée. Cette amorphisation est suivie d'un recuit de recristallisation en phase solide dit de SPER (« Solid Phase Epitaxial Regrowth »). À des températures inférieures à 500°C, la recristallisation par recuit SPER est très lente, voire infructueuse et le recuit SPER nécessite en pratique un budget thermique proche de celui utilisé pour déclencher la fracture. En conséquence, il n'est pas possible de mettre en œuvre cette solution avant le collage du substrat donneur avec le substrat receveur. Par ailleurs, pour permettre la recristallisation pendant le recuit de SPER, il est nécessaire de laisser une partie de la couche mince transférée sans aucune amorphisation. De ce fait, la guérison des défauts proches du fond de la couche n'est pas possible. Enfin, la recristallisation SPER présente des difficultés à recristalliser les derniers nanomètres proches de la surface du fait de vitesses de recristallisation différentes selon les directions cristallines et de la présence de défauts d'empilements dans la direction cristalline (111).

### EXPOSÉ DE L'INVENTION

L'invention s'inscrit dans un contexte où :
- une technique de guérison des défauts liés à l'implantation ionique dans le substrat donneur qui serait mise en œuvre avant transfert ne peut venir traiter le substrat donneur à haute température (typiquement à une température supérieure à 300°C) après l'implantation ionique au risque de provoquer un bullage, c'est à dire une maturation de microcavités dans le plan de fragilisation qui, en l'absence d'un raidisseur rapporté sur le substrat donneur, conduirait à une déformation de sa surface susceptible de contrarier un collage avec le substrat receveur ; et
- une technique de guérison des défauts liés à l'implantation ionique dans le substrat donneur qui serait quant à elle mise en œuvre après transfert ne peut incorporer un traitement thermique au-delà de 500°C pour les raisons exposées ci-dessus.

L'invention a pour objectif de proposer une solution de guérison des défauts liés à l'implantation qui puisse être mise en œuvre à relativement basse température et être ainsi appliquée au transfert d'une couche semi-conductrice sur un substrat receveur présentant des caractéristiques qui interdisent des traitements à haute température et qui s'affranchisse des inconvénients des solutions discutées précédemment.

À cet effet, l'invention propose un procédé de guérison de défauts liés à une implantation d'espèces réalisée dans un substrat donneur en un matériau semi-conducteur pour y former un plan de fragilisation séparant une couche mince d'une partie massive du substrat donneur.

Ce procédé comporte les étapes suivantes :
- amorphisation superficielle de la couche mince ;
- application d'un traitement thermique à la couche mince superficiellement amorphisée ;
- après la formation du plan de fragilisation, application d'un recuit laser à la couche mince superficiellement amorphisée et thermiquement traitée pour la recristalliser en phase solide.

Certains aspects préférés mais non limitatifs de ce procédé sont les suivants :
- l'amorphisation superficielle de la couche mince est induite par une implantation ionique ;
- le recuit laser est réalisé au moyen d'une irradiation de la couche mince avec une ou plusieurs impulsions laser, la durée de la ou des impulsions laser étant inférieure à une microseconde, de préférence comprise entre 20 et 200 nanosecondes ;
- la ou les impulsions laser présentent une longueur d'onde inférieure à 450 nm ;
- la ou les impulsions lasser laser présentent une densité surfacique d'énergie choisie pour échauffer une portion avant de la couche mince à une température supérieure à 1000°C, de préférence supérieure à 1200°C ;
- les étapes d'amorphisation superficielle de la couche mince et d'application d'un traitement thermique à la couche mince superficiellement amorphisée sont mises en œuvre avant la formation du plan de fragilisation ;
- les étapes d'amorphisation superficielle de la couche mince et d'application d'un traitement thermique à la couche mince superficiellement amorphisée sont mises en œuvre après la formation du plan de fragilisation ;
- les étapes d'amorphisation superficielle de la couche mince, d'application d'un traitement thermique à la couche mince superficiellement amorphisée et d'application du recuit laser sont mises en œuvre après fracture le long du plan de fragilisation et transfert de la couche mince sur un substrat receveur;
- la couche mince incorpore une couche d'arrêt de gravure ;
- le traitement thermique appliqué à la couche mince superficiellement amorphisée est un recuit à une température inférieure à 450°C ;
- le traitement thermique appliqué à la couche mince superficiellement amorphisée est réalisé au cours d'une opération de dépôt d'une couche de collage sur le substrat donneur ;

Il comprend avant l'application du recuit laser une étape d'implantation de dopants électriques dans la couche mince.

L'invention s'étend à un procédé de transfert d'une couche mince d'un substrat donneur en un matériau semi-conducteur vers un substrat receveur, le procédé comprenant les étapes de :
- formation par implantation d'espèces d'un plan de fragilisation dans le substrat donneur, ledit plan séparant la couche mince d'une partie massive du substrat donneur ;
- mise en contact du substrat donneur et du substrat receveur pour former un ensemble à fracturer ;
- fracture de l'ensemble à fracturer le long du plan de fragilisation de manière à transférer la couche mince ;
caractérisé en ce qu'il comporte :
- des étapes d'amorphisation superficielle de la couche mince et d'application d'un traitement thermique à la couche mince superficiellement amorphisée ; et
- après la formation du plan de fragilisation et avant la mise en contact, une étape d'application d'un recuit laser à la couche mince superficiellement amorphisée et thermiquement traitée pour la recristalliser en phase solide.

La fracture comprend typiquement un traitement thermique de fragilisation appliqué à l'ensemble à fracturer qui échauffe le plan de fragilisation à une température supérieure à celle à laquelle il est échauffé par le recuit laser.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence à la figure annexée sur laquelle :

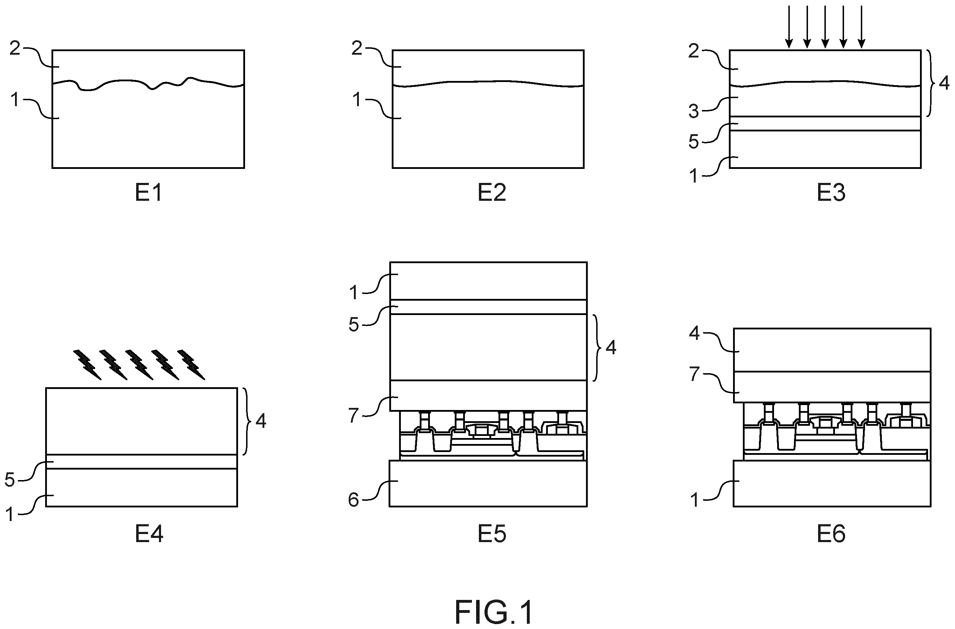

La figure 1 est un schéma d'un exemple de procédé selon l'invention de transfert d'une couche mince semi-conductrice dans lequel est réalisée une guérison de défauts liés à l'implantation.

### DESCRIPTION DÉTAILLÉE

L'invention porte sur un procédé de guérison de défauts occasionnés par une implantation d'espèces réalisée dans un substrat semi-conducteur, dit substrat donneur, pour y former un plan de fragilisation séparant une couche mince d'une partie massive du substrat.

L'invention trouve notamment application au transfert de la couche mince sur un substrat receveur conformément à la technologie Smart Cut™, et plus particulièrement sur un substrat receveur présentant des caractéristiques qui interdisent des traitements à haute température, typiquement à plus de 500°C. Dans ce cadre, le procédé selon l'invention permet de guérir les défauts présents dans la couche mince avant son transfert sur le substrat receveur. Le procédé selon l'invention peut également permettre de guérir les défauts présents dans la couche mince après son transfert sur le substrat receveur.

On décrit dans ce qui suit en référence à la figure 1 différentes étapes E1-E6 d'un procédé de transfert d'une couche mince d'un substrat donneur en un matériau semi-conducteur vers un substrat receveur dans lequel le procédé de guérison selon l'invention est mis en œuvre avant transfert. Il est entendu qu'une telle guérison peut similairement être réalisée après transfert, indépendamment ou en complément d'une guérison avant transfert.

Ce procédé débute par une étape de fourniture du substrat donneur 1 qui peut être un substrat de silicium, ou en tout autre matériau semi-conducteur. À titre d'exemples, il peut s'agir de silicium-germanium, de germanium ou d'un matériau III-V.

Dans une étape E1, le substrat donneur 1 est soumis à une étape d'amorphisation superficielle, par exemple à l'aide d'une implantation d'ions lourds, pour former une zone amorphe superficielle 2 qui va constituer une portion avant de la couche mince à transférer.

Cette implantation peut être à base notamment d'une ou plusieurs des espèces suivantes : silicium, germanium, phosphore, arsenic, azote ou argon avec une dose typiquement comprise entre 10¹⁴ et 10¹⁶ at/cm². À titre d'exemple, avec une dose de 2.10¹⁵ at/cm², une implantation de germanium conduit à une profondeur amorphisée allant de 4,7 nm à 10,6 nm pour une énergie d'implantation allant de 1 keV à 3,5 keV.

Dans une étape E2, un recuit basse température est appliqué au substrat donneur qui vient recuire la couche mince superficiellement amorphisée. Ce recuit permet de lisser l'interface entre la zone amorphe 2 et le substrat cristallin 1. Ce recuit de lissage est typiquement réalisé à une température inférieure à 450°C, ce qui autorise la réalisation du procédé de guérison selon l'invention après transfert. Ce recuit est généralement réalisé à une température supérieure à une température supérieure à 200°C, de préférence à une température comprise entre 300°C et 450 °C.

Dans une variante de réalisation, le budget thermique de ce recuit de lissage est apporté au cours d'une opération de dépôt d'une couche de collage, par exemple en un oxyde ou un nitrure, sur le substrat donneur. Cette couche de collage est choisie de manière à ne pas entraver la recristallisation en phase solide ultérieure de la zone amorphe qui réalisée par recuit laser. La couche de collage peut ainsi être réalisée en un matériau peu absorbant vis-à-vis du rayonnement du faisceau laser (par exemple de l'oxyde de silicium, du nitrure de silicium ou tout autre matériau conduisant à une absorption inférieure à 10% dans la gamme de longueur d'ondes du faisceau laser) ou présenter une épaisseur suffisamment faible pour qu'une partie majoritaire de l'énergie apportée par le laser soit absorbée par la zone amorphe (soit pour la plupart des semi-conducteurs, une épaisseur typiquement inférieure à 20 nm, de préférence inférieure à 10 nm).

Dans une variante, le procédé comprend une opération de dépôt d'une couche de collage indépendante du recuit de lissage. On relèvera que si la température de dépôt est supérieure à 500°C, une recristallisation de la zone amorphe va s'opérer lors du dépôt. Il faut alors dans ce cas de figure prévoir une profondeur d'amorphisation plus importante pour que cette recristallisation ne soit que partielle. On relèvera par ailleurs que si la température de dépôt est suffisamment basse, typiquement inférieure à <200°C, alors cette opération de dépôt peut être effectuée de façon indifférente avant ou après l'implantation d'ions légers de l'étape suivante.

Le procédé comprend ensuite une étape E3 de formation d'un plan de fragilisation 5 dans l'épaisseur du substrat donneur. Ce plan de fragilisation est plus particulièrement formé en soumettant une surface avant du substrat donneur à une implantation d'ions légers, typiquement de l'hydrogène et/ou de l'hélium. Le plan de fragilisation 4 délimite une couche mince 4 et une partie massive du substrat donneur 1. Les espèces traversent la couche mince 4 lors de l'implantation et y causent des défauts qu'il convient de guérir. Ce plan de fragilisation se trouve typiquement entre 250 et 300 nm sous la surface. Cette profondeur peut être ajustée en jouant sur les conditions d'implantation et plus particulièrement sur l'énergie d'implantation. Cette profondeur est notamment choisie pour la zone amorphe 2 reste à distance du plan de fragilisation 5, de préférence à plus de 100 nm, voire à plus de 150 nm, afin de ne pas gêner la propagation ultérieure de l'onde de fracture. La couche mince comprend ainsi une portion avant constituée de la zone amorphe 2 et d'une portion arrière 3 de matériau cristallin au contact du plan de fragilisation.

Le procédé comprend ensuite une étape E4 au cours de laquelle un recuit laser est appliqué à la couche mince superficiellement amorphisée 4 pour la recristalliser en phase solide. Ce recuit laser permet plus particulièrement de recristalliser en phase solide la zone amorphe 2 de la couche mince 4. La recristallisation en phase solide permet de guérir des défauts présents dans la couche mince du fait de l'implantation de l'étape E3.

Ce recuit laser est un recuit sélectif en profondeur qui provoque un échauffement de la couche mince dont l'intensité décroit avec la profondeur d'une face avant de la couche semi-conductrice en direction du plan de fragilisation et est donc maximale au voisinage de la face avant. Cette décroissance de l'intensité de l'échauffement permet de chauffer préférentiellement la zone endommagée traversée par l'implantation d'ions légers à très haute température ce qui permet d'y guérir les défauts liés à l'implantation. Et l'élévation en température étant confinée dans une portion avant de la couche mince, on évite de provoquer un échauffement du plan de fragilisation qui provoquerait un bullage. Une portion arrière de la couche mince au contact du plan de fragilisation peut, du fait de la sélectivité en profondeur du recuit, ne pas être guérie.

Ainsi, dans le cadre du procédé Smart Cut™, ce recuit localisé ne va pas engendrer de bullage et peut donc être réalisé avant même de coller les substrats donneur et receveur, le traitement thermique de fragilisation du plan de fragilisation qui concourt au transfert de la couche semi-conductrice pouvant alors être réalisé *a posteriori.* La couche mince est ainsi guérie avant même d'être transférée. De cette manière, le substrat receveur qui peut être sensible à la température ne subit thermiquement que le traitement thermique de fragilisation qui est réalisé à une température suffisamment faible (typiquement inférieure à 500°C) et/ou sur une durée suffisamment courte pour garantir l'intégrité du substrat receveur ou de ses composants.

Suite à la guérison, le procédé comprend, lors d'une étape E5, la mise en contact du substrat donneur avec un substrat receveur 5 pour former un ensemble à fracturer. Cette formation peut être réalisée par assemblage direct, par exemple par adhésion moléculaire, le cas échéant par l'intermédiaire d'une couche de collage 7. Comme représenté sur la figure 1, le substrat receveur 6 peut comprendre des dispositifs électroniques déjà fabriqués.

Puis, suite à la mise en contact, le procédé comprend, lors d'une étape E6, une fracture de l'ensemble à fracturer le long du plan de fragilisation 5, ce qui conduit au détachement de la couche mince 4 du substrat donneur et à son transfert sur le substrat receveur. Cette fracture comprend un traitement thermique de fragilisation appliqué à l'ensemble à fracturer. Ce traitement thermique fournit l'énergie suffisante pour qu'une onde de fracture, une fois initiée, se propage de manière auto-entretenue. Dans une première variante, le traitement thermique de fragilisation est suffisant à lui seul pour initier l'onde de fracture. Dans une seconde variante, le procédé de transfert comprend un apport d'énergie additionnelle localisé, après ou pendant le traitement thermique de fragilisation, pour initier l'onde de fracture. Cette énergie peut être d'origine mécanique, thermique ou de toute autre origine. Il peut s'agir par exemple d'un chauffage localisé réalisé par un laser ou d'un apport d'énergie par ultrasons.

Un amincissement de la couche semi-conductrice peut ensuite être réalisé pour n'en conserver qu'une épaisseur utile correspondant au plus à la portion avant guérie. Dans l'exemple représenté, une couche mince cristalline a été transférée sur le substrat receveur et peut faire office de nouveau niveau pour la fabrication de dispositifs électroniques dans le cadre d'une intégration 3D séquentielle.

Dans un mode de réalisation possible, avant amorphisation superficielle, la couche mince peut intégrer une couche d'arrêt à la gravure qui sera utilisée après transfert pour concourir à la réalisation de l'amincissement. On peut pour cela procéder à une croissance épitaxiale de la couche d'arrêt (par exemple en SiGe) sur le substrat donneur (par exemple en Si) puis à la croissance épitaxiale du matériau de la couche mince (par exemple en Si). Dans ce cas, la profondeur d'amorphisation peut être inférieure (de préférence) ou supérieure à la profondeur où se trouve cette couche d'arrêt. L'implantation d'ions légers est réalisée de manière à créer le plan de fragilisation à une profondeur supérieure à celle de la couche d'arrêt.

Dans un mode de réalisation possible, il est possible de doper électriquement tout ou partie de la zone amorphisée ou qui va être amorphisée avec des dopants classiques comme du Bore, du Phosphore ou encore de l'Arsenic. L'implantation de dopants est réalisée avantageusement avant l'étape E4 de recuit laser de sorte à permettre de réduire la température du recuit laser et/ou d'augmenter la vitesse de recristallisation. A titre d'exemple, l'implantation de dopants peut être réalisée indifféremment avant ou après l'étape E1 d'amorphisation ou l'étape E2 de recuit de lissage.

Ainsi le procédé de transfert comprend, avant la mise en contact des substrats donneur et receveur, une guérison de défauts de la couche mince liés à l'implantation d'espèces. Comme indiqué précédemment, cette guérison comprend un recuit localisé du substrat donneur provoquant un échauffement de la couche mince dont l'intensité est maximale en surface et décroit de la face avant de la couche mince en direction du plan de fragilisation 5. Ce recuit sélectif en profondeur peut notamment être réalisé en soumettant la surface avant du substrat donneur à une irradiation laser. L'irradiation laser peut être pratiquée à pression atmosphérique ou encore sous vide, de préférence sous atmosphère inerte ou sous atmosphère réductrice.

L'irradiation laser est de préférence une irradiation impulsionnelle dont les conditions opératoires sont choisies pour échauffer la zone amorphe 2 de la couche mince sans provoquer un bullage du plan de fragilisation 5.

Notamment, la longueur d'onde de l'irradiation laser est de préférence choisie pour conduire à une forte absorption du rayonnement par le matériau du substrat donneur. De telle manière, l'essentiel du rayonnement envoyé sur le substrat donneur implanté peut être absorbé dans les premiers nanomètres, typiquement par les premiers 50 nm de matériau. On choisit par exemple un laser de longueur d'onde inférieure à 450 nm dans le cas où le substrat donneur est en silicium, en germanium ou en silicium-germanium.

La durée d'une impulsion laser est quant à elle choisie suffisamment courte pour que la chaleur déposée dans les premiers nanomètres n'ait pas le temps de diffuser significativement en profondeur jusqu'au plan de fragilisation 5 sous peine de provoquer le bullage. Par exemple, dans le cas d'un substrat donneur présentant un plan de fragilisation localisé en profondeur entre 150 et 1500 nm de la face avant de la couche mince, la durée d'impulsion est choisie sous la microseconde, typiquement entre 20 et 200 ns.

D'autres conditions opératoires de l'irradiation laser pouvant être contrôlées sont la densité surfacique d'énergie et le nombre d'impulsions irradiant une même région de surface. Ces autres conditions sont choisies de sorte à atteindre une température suffisante pour que la portion avant guérie de la couche mince présente une épaisseur au moins égale à l'épaisseur utile de la couche semi-conductrice dans le composant final. Par exemple, on peut être amené à transférer une couche mince d'épaisseur 250 nm pour *in fine* n'en conserver que les derniers nanomètres (5 à 30 nm pour une couche utile très fine, ou encore 50 à 150 nm pour une couche utile plus épaisse). Le recuit laser vient ainsi guérir le cristal sur cette épaisseur utile de la couche mince. Pour un substrat donneur en silicium, la densité d'énergie est alors choisie pour dépasser 1000°C, plus favorablement 1200°C, dans toute l'épaisseur utile.

Afin d'assurer une recristallisation en phase solide, le recuit laser est réalisé dans un régime sous la fusion selon lequel l'irradiation laser comprend une ou plusieurs impulsions ayant chacune une densité d'énergie choisie pour ne pas entraîner la fusion de la surface irradiée.

Dans un mode de réalisation possible, la température du substrat donneur est élevée avant et pendant le recuit laser au moyen d'un élément chauffant configuré pour réaliser un chauffage de l'intégralité du substrat donneur à une température choisie pour ne pas provoquer un bullage du plan de fragilisation, par exemple à une température comprise entre 50°C et 450°C et de préférence comprise entre 100°C et 350°C.

L'invention permet au moyen d'un recuit laser suffisamment court (inférieur à la microseconde) et avec une longueur d'onde convenablement sélectionnée (inférieure à 600 nm) de limiter l'échauffement à la surface et à un volume très proche de la surface du substrat donneur. Ceci permet de chauffer préférentiellement la zone endommagée traversée par l'implantation ionique sur une profondeur dépendante de la longueur d'onde et de la durée de l'impulsion laser. Ce procédé permet de monter à de très hautes températures dans la portion avant de la couche mince, tout en confinant cet échauffement pour ne pas provoquer de bullage du plan de fragilisation 4. Ces hautes températures, en plus de permettre la guérison des défauts liés à l'implantation et ainsi de retrouver les propriétés électriques initiales du matériau semi-conducteur, peuvent en outre permettre l'activation de dopants ou d'autres traitements thermiques à haute température qui ne peuvent pas être utilisés sur des substrats susceptibles d'être endommagés. En effet, de par l'utilisation du recuit laser avant même le collage, il est possible de s'affranchir des contraintes liées aux limitations de budget thermique, comme la nécessité d'avoir une couche thermiquement isolante par exemple.

Dans un mode de réalisation possible, le recuit laser peut venir irradier une surface de taille variable entre quelques mm² et quelques cm². La forme et la taille de cette surface peut être contrôlée au moyen de masques. Une partie du substrat plutôt qu'une autre est ainsi préférentiellement soumise au recuit ce qui permet de réaliser une guérison localisée de la couche mince.

On a décrit ci-dessus un procédé de guérison pré-transfert dans lequel les étapes d'amorphisation superficielle de la couche mince et d'application d'un traitement thermique à la couche mince superficiellement amorphisée sont mises en œuvre avant la formation du plan de fragilisation et dans lequel l'étape d'application du recuit laser est mise en œuvre après la formation du plan de fragilisation.

Selon un procédé de guérison pré-transfert alternatif, ces trois étapes d'amorphisation superficielle, d'application d'un traitement thermique et d'application du recuit laser sont mises en œuvre après la formation du plan de fragilisation. L'étape d'application d'un traitement thermique est alors réalisée à une température choisie pour ne pas provoquer un bullage du plan de fragilisation, par exemple une température inférieure à 300 °C.

Comme indiqué précédemment, l'invention s'étend à un procédé de guérison post-transfert dans les étapes d'amorphisation superficielle de la couche mince, d'application d'un traitement thermique à la couche mince superficiellement amorphisée et d'application du recuit laser sont mises en œuvre après fracture le long du plan de fragilisation et transfert de la couche mince sur un substrat receveur.

## Revendications

1. Procédé de guérison de défauts liés à une implantation d'espèces réalisée dans un substrat donneur (1) en un matériau semi-conducteur pour y former un plan de fragilisation (5) séparant une couche mince (4) d'une partie massive du substrat donneur, **caractérisé en ce qu'**il comporte les étapes suivantes :
- amorphisation superficielle de la couche mince ;
- application d'un traitement thermique à la couche mince superficiellement amorphisée ;
- après la formation du plan de fragilisation, application d'un recuit laser à la couche mince superficiellement amorphisée et thermiquement traitée pour la recristalliser en phase solide.

2. Procédé selon la revendication 1, dans lequel l'amorphisation superficielle de la couche mince est induite par une implantation ionique.

3. Procédé selon l'une des revendications 1 et 2, dans lequel le recuit laser est réalisé au moyen d'une irradiation de la couche mince (4) avec une ou plusieurs impulsions laser, la durée de la ou des impulsions laser étant inférieure à une microseconde, de préférence comprise entre 20 et 200 nanosecondes.

4. Procédé selon la revendication 3, dans lequel la ou les impulsions laser présentent une longueur d'onde inférieure à 450 nm.

5. Procédé selon l'une des revendications 3 et 4, dans lequel la ou les impulsions lasser laser présentent une densité surfacique d'énergie choisie pour échauffer une portion avant de la couche mince à une température supérieure à 1000°C, de préférence supérieure à 1200°C.

6. Procédé selon l'une des revendications 1 à 5, dans lequel les étapes d'amorphisation superficielle de la couche mince et d'application d'un traitement thermique à la couche mince superficiellement amorphisée sont mises en œuvre avant la formation du plan de fragilisation (5).

7. Procédé selon l'une des revendications 1 à 5, dans lequel les étapes d'amorphisation superficielle de la couche mince et d'application d'un traitement thermique à la couche mince superficiellement amorphisée sont mises en œuvre après la formation du plan de fragilisation (5).

8. Procédé selon l'une des revendications 1 à 5, dans lequel les étapes d'amorphisation superficielle de la couche mince, d'application d'un traitement thermique à la couche mince superficiellement amorphisée et d'application du recuit laser sont mises en œuvre après fracture le long du plan de fragilisation et transfert de la couche mince sur un substrat receveur (6).

9. Procédé selon l'une des revendications 1 à 8, dans lequel la couche mince incorpore une couche d'arrêt de gravure.

10. Procédé selon l'une des revendications 1 à 9, dans lequel le traitement thermique appliqué à la couche mince superficiellement amorphisée est un recuit à une température inférieure à 450°C.

11. Procédé selon la revendication 10, dans lequel le traitement thermique appliqué à la couche mince superficiellement amorphisée est réalisé au cours d'une opération de dépôt d'une couche de collage (7) sur le substrat donneur.

12. Procédé selon l'une des revendications 1 à 10, comprenant avant l'application du recuit laser une étape d'implantation de dopants électriques dans la couche mince.

13. Procédé de transfert d'une couche mince (4) d'un substrat donneur (1) en un matériau semi-conducteur vers un substrat receveur (6), le procédé comprenant les étapes de :
- formation par implantation d'espèces d'un plan de fragilisation (5) dans le substrat donneur, ledit plan séparant la couche mince (4) d'une partie massive du substrat donneur ;
- mise en contact du substrat donneur (1) et du substrat receveur (6) pour former un ensemble à fracturer ;
- fracture de l'ensemble à fracturer le long du plan de fragilisation (5) de manière à transférer la couche mince ;
**caractérisé en ce qu'**il comporte :
- des étapes d'amorphisation superficielle de la couche mince et d'application d'un traitement thermique à la couche mince superficiellement amorphisée ; et
- après la formation du plan de fragilisation et avant la mise en contact, une étape d'application d'un recuit laser à la couche mince superficiellement amorphisée et thermiquement traitée pour la recristalliser en phase solide.

14. Procédé selon la revendication 13, dans lequel la fracture comprend un traitement thermique de fragilisation appliqué à l'ensemble à fracturer qui échauffe le plan de fragilisation à une température supérieure à celle à laquelle il est échauffé par le recuit laser.
